Europäisches Patentamt

European Patent Office

Office européen des brevets

(19)

(11) **EP 0 557 186 B1**

(12) **FASCICULE DE BREVET EUROPEEN**

(45) Date de publication et mention
de la délivrance du brevet:
**24.07.1996 Bulletin 1996/30**

(51) Int Cl.$^6$: **H01L 31/0352**

(21) Numéro de dépôt: **93400392.2**

(22) Date de dépôt: **17.02.1993**

(54) **Détecteur photoélectrique à puits quantiques à détectivité améliorée**

Photoelektrischer Detektor mit Quantentöpfen und verbesserter Detectivität

Quantumwell photoelectric detector with enhanced detectivity

(84) Etats contractants désignés:
**DE FR GB**

(30) Priorité: **18.02.1992 FR 9201826**

(43) Date de publication de la demande:
**25.08.1993 Bulletin 1993/34**

(73) Titulaire: **FRANCE TELECOM
75015 Paris (FR)**

(72) Inventeurs:
 • **Deveaud-Pledran, Benoît
   F-22300 Lannion (FR)**
 • **Gerard, Jean-Michel
   F-75005 Paris (FR)**

(74) Mandataire: **Martin, Jean-Jacques et al
Cabinet REGIMBEAU
26, Avenue Kléber
75116 Paris (FR)**

(56) Documents cités:
   **EP-A- 0 463 907        US-A- 4 873 555**

 • **APPLIED PHYSICS LETTERS, vol. 45, no. 6, 15
   Septembre 1984, New York, US, pp. 649-651;
   COON et al.: 'New mode of IR detection using
   quantum wells'**
 • **PHYSICAL REVIEW LETTERS vol. 67, no. 16, 14
   Octobre 1991, New York, US, pp. 2231-2234; C.T.
   LIU et al.: 'Steady-state photovoltaic effect in
   asymmetrical graded superlattices'**
 • **APPLIED PHYSICS LETTERS, vol. 57, no. 4, 23
   Juillet 1990, New York, US, pp. 383-385; LEVINE
   et al.: 'Tunable long-wavelength detectors using
   graded barrier quantum wells grown by electron
   beam source molecular beam epitaxy'**

## Description

La présente invention concerne un détecteur photoélectrique du type présentant une structure à puits quantiques multiples.

L'invention trouve une application particulièrement avantageuse dans le domaine des détecteurs infrarouge, notamment dans la gamme de fréquences $2x10^{13}$ - $4x10^{13}$ Hz.

Jusqu'à un passé très récent, les détecteurs dans la gamme $2x10^{13}$ - $4x10^{13}$ Hz étaient réalisés avec des matériaux constitués par des éléments des colonnes II et VI de la classification de Mendeleiev, principalement HgCdTe. Ces matériaux présentant une bande interdite de la largeur requise (entre 100 et 200 meV), ils possèdent une détectivité remarquable. Leur principal défaut réside dans la difficulté de réaliser des jonctions p-n ou des contacts de bonne qualité. C'est cette difficulté qui a limité l'expansion de dispositifs basés sur la détection à base de matériaux II-VI. En particulier, on ne sait pas encore réaliser de façon fiable des matrices de photodétecteurs de dimension suffisante.

Au début des années 80, il a été proposé d'utiliser pour détecter dans la gamme $2x10^{13}$ - $4x10^{13}$ Hz, non plus des transitions bande à bande, mais des transitions intersousbande dans un puits quantique. Ce type de détecteur photoélectrique présente, de façon très générale, une structure à puits quantique constitué par une barrière amont réalisée en un premier matériau semiconducteur, un puits réalisé en un deuxième matériau semiconducteur, et une barrière aval réalisée en un troisième matériau semiconducteur, chaque matériau semiconducteur étant défini par sa composition chimique, et la conductibilité électrique dans le détecteur étant assurée par propagation, dans le sens allant de la barrière amont à la barrière aval, de porteurs de charge donnée dans une bande électronique de type donné présentant, dans chacun desdits matériaux, un extremum d'énergie.

De façon pratique, les détecteurs photoélectriques à puits quantiques sont généralement réalisés par épitaxies successives sur un substrat de différentes couches desdits matériaux semiconducteurs.

Dans un puits quantique, le confinement des porteurs dans la direction de croissance épitaxiale provoque la formation de niveaux d'énergie quantifiés. Par exemple, pour une largeur de puits de l'ordre de 5 nm dans un système où les premier et troisième matériaux sont constitués par du $Ga_{0,7}Al_{0,3}As$ et le deuxième matériau du GaAs, on obtient une séparation entre les deux premiers niveaux qui correspond à la longueur d'onde recherchée. Pour le système précité, les porteurs sont des électrons et ladite bande électronique la bande de conduction. Si l'on dope le puits avec des donneurs, on obtient alors une population d'électrons sur le niveau fondamental du puits, et le système peut absorber pourvu que la lumière incidente soit polarisée correctement ; lorsque les porteurs sont des électrons, les transitions ne sont autorisées que si la polarisation a une composante parallèle à la direction de croissance des couches.

Le principe de base du détecteur photoélectrique à puits quantiques ainsi énoncé a été par la suite amélioré par de nombreuses modifications. Par exemple, les transitions ne se font pas en fait entre deux niveaux quantifiés dans le puits, mais entre un niveau confiné et une minibande de niveaux au-dessus des barrières. De cette façon, les électrons photoexcités ont une probabilité plus importante de participer au photocourant.

Il a été également proposé par B.F. Levine et al (Appl. Phys. Lett. 57(4), 1990, pp 383-385) d'introduire entre les deux barrières du puits une dissymétrie limitée de façon à obtenir un détecteur accordable sur une certaine plage de longueur d'onde. Ce détecteur comporte une succession de couches puits en GaAs et barrieres en $Ga_{1-x}Al_xAs$ dont la composition varie graduellement de x=0,24 à x=0,28 dans le sens de propagation des porteurs.

Une autre amélioration consiste à graver sur le contact supérieur du photodétecteur un réseau de période telle que, compte tenu des règles de sélection, la lumière incidente se couple de façon plus efficace avec le puits quantique multiple.

On peut de cette façon, en bénéficiant des facilités offertes par la maturité des processus technologiques sur les matériaux à base de GaAs par exemple, réaliser sans trop de difficultés des matrices de photodétecteurs 256 x 256. La démonstration de ce type de matrices a été effectuée à la température de 60 K. Elle permet une résolution thermique de l'image de l'ordre de 0,1 K. Ceci constitue déjà un progrès important par rapport aux systèmes concurrents.

Cependant, pour réaliser des détecteurs photoélectriques facilement utilisables, il est nécessaire d'élever autant que possible la température de fonctionnement.

Pour parvenir à un tel objectif, il convient d'améliorer la détectivité des détecteurs à puits quantiques. Différents paramètres affectent cette détectivité, en particulier la valeur du coefficient d'absorption intersousbande. Différentes techniques ont été proposées pour améliorer ce coefficient d'absorption, par exemple en entourant le puits par des barrières fines de composition différente de la composition des barrières principales. Mais, en général, ce qui est gagné d'un côté est perdu d'un autre côté. Dans le cas de l'exemple précédent, si l'on gagne en absorption, on perd en coefficient de transfert des électrons vers la barrière.

Une des limitations fondamentales du rendement des détecteurs à puits quantiques connus réside dans le temps de capture dans le puits d'un électron photoexcité dans la minibande du détecteur. En effet, on peut écrire d'une manière très simplifiée la responsivité R de ce type de structure comme le produit du coefficient d'absorption a par la probabilité pour un électron de rejoindre le contact sans être repiégé dans un puits. Si l'on appelle $\tau_{capt}$ le temps moyen

de capture, et $\tau_{drift}$ le temps que met un électron à traverser la structure, on obtient :

$$R \propto a. \tau_{capt}/ \tau_{drift} \qquad (1)$$

On notera g, coefficient de gain, le rapport $\tau_{capt}/\tau_{drift}$. Ceci signifie que, si le temps de capture moyen est plus long que le temps de déplacement d'un contact à l'autre, le détecteur présentera du gain. La détectivité du photodétecteur dépend non seulement de R, mais aussi de la contribution du bruit i du courant d'obscurité du dispositif. L'expérience montre que i est un bruit de grenaille à une très bonne approximation ; si Id est le courant d'obscurité, on a :

$$i \propto \sqrt{Id.g}$$

et

$$D \propto R/i \propto ax\sqrt{g}/\sqrt{Id}$$

La Demanderesse a analysé en détail et mesuré par des expériences de luminescence résolue dans le temps avec une précision temporelle meilleure que la picoseconde, les processus de capture d'un électron dans un puits quantique. Les résultats de ces investigations ont montré que le temps de capture dans une structure classique est toujours extrêmement court, de l'ordre de la picoseconde ou moins. Le temps de transit d'un électron dans la structure est quant à lui plutôt de l'ordre de 10 ps. Il en résulte une limitation des performances des détecteurs à puits quantiques actuellement connus.

Aussi, la présente invention a pour but de proposer un détecteur photoélectrique présentant une structure à puits quantiques multiples dont la détectivité serait améliorée par une modification de la structure qui augmenterait le temps de capture des porteurs photocréés.

Selon la présente invention, un détecteur photoélectrique présentant la structure générale à puits quantique précitée est remarquable en ce que, lesdits matériaux semiconducteurs étant au moins partiellement dopés en porteurs, les premier et troisième matériaux semiconducteurs ont une composition chimique telle que la différence d'énergie, au niveau desdites barrières, entre l'extremum d'énergie de ladite bande électronique dans le premier matériau semiconducteur et l'extremum d'énergie de ladite bande électronique dans le troisième matériau semiconducteur, est supérieure en valeur absolue à l'énergie maximale des phonons longitudinaux optiques dans le matériau semiconducteur constituant un puits. Selon l'invention, la structure est formée d'un empilement alterné de couches du deuxième matériau semiconducteur séparées par des couches d'un matériau semiconducteur présentant, de la barrière aval d'un puits à la barrière amont du puits suivant dans le sens de propagation des porteurs, une composition chimique variant graduellement de la composition du troisième matériau semiconducteur à celle du premier matériau semiconducteur.

Ainsi, au lieu de présenter des barrières de composition identique, ou quasi identique, comme dans les détecteurs à puits quantiques connus, la composition des barrières du photodétecteur conforme à l'invention varie de manière que l'énergie des niveaux d'un côté du puits soit supérieure de plus de 50 meV, par exemple pour le système GaAlAs/ GaAs, à l'énergie des électrons de l'autre côté. De cette façon, lorsque l'on place le détecteur photoélectrique de l'invention sous champ électrique, comme c'est le cas en fonctionnement, les porteurs qui arrivent au bord d'un puits subissent deux effets qui limitent la probabilité de capture des porteurs :

- leur vitesse est augmentée du fait de leur plus grande énergie cinétique, acquise au passage de la discontinuité,

- leur probabilité de capture par émission d'un phonon optique est diminuée puisque même après émission de ce type de phonon, le porteur sera encore dans les états de la minibande. La largeur du puits étant assez faible, on s'affranchit pratiquement des problèmes d'ionisation par impact.

Des expériences de luminescence en continu et avec une résolution picoseconde ont permis de montrer l'efficacité de ce type de structure dans la réduction du taux de capture dans un puits quantique. Selon l'équation (1), le rendement en est augmenté d'autant.

Dans les structures à puits quantiques mettant en oeuvre des matériaux semiconducteurs répondant à la formule chimique générale $Ga_xAl_{1-x}As$, les porteurs sont, de préférence, des électrons de la bande de conduction. Dans ce cas, le signe des porteurs étant négatif, l'extremum d'énergie de la bande de conduction dans la barrière aval est inférieur à l'extremum d'énergie de la bande de conduction dans la barrière amont.

Il convient de signaler toutefois que l'invention présente l'avantage important de permettre la réalisation de détecteurs photoélectriques à puits quantiques multiples dans lesquels les porteurs sont des trous de la bande de valence. Tel est le cas des matériaux de formule générale $Si_xGe_{1-x}$ dont la compatibilité avec la technologie sur silicium présente l'avantage que les photodétecteurs ainsi obtenus peuvent être intégrés à la plupart des composants électroniques usuels à base de silicium. Pour ce type de système, l'extremum d'énergie de la bande de valence dans la barrière amont doit être inférieur à l'extremum d'énergie de la bande de valence dans la barrière aval.

La description qui va suivre, en regard des dessins annexés donnés à titre d'exemples non limitatifs, fera bien comprendre en quoi consiste l'invention et comment elle peut être réalisée.

La figure 1 est une vue en coupe d'un détecteur photoélectrique à un puits quantique.

La figure 2 est un diagramme de la structure de bande dans chaque couche du détecteur photoélectrique de la figure 1.

La figure 3 est un premier diagramme de puits quantique sous champ électrique nul.

La figure 4 est un deuxième diagramme de puits quantique sous champ électrique nul.

La figure 5 est un diagramme de fonctionnement sous champ électrique non nul de la structure de puits quantique de la figure 4.

Les figures 6a et 6b sont des diagrammes d'une structure à puits quantiques multiples conforme à l'invention sous champ électrique respectivement nul et non nul.

La figure 7 est un diagramme donnant, sous champ électrique nul, la position des extrema de la bande de conduction pour une première structure selon l'invention à puits quantiques multiples à croisements d'extrema Γ (trait continu) et X (trait pointillé).

La figure 8 est le diagramme de fonctionnement correspondant à la structure de la figure 7.

La figure 9 est un diagramme donnant, sous champ électrique nul, la position des extrema de la bande de conduction pour une deuxième structure selon l'invention, à puits quantiques multiples à croisements d'extrema Γ (trait continu) et X (trait pointillé).

La figure 10 est le diagramme de fonctionnement correspondant à la structure de la figure 9.

La figure 11 est un diagramme de la structure de puits quantique d'un détecteur photoélectrique du type Si(Ge).

La figure 12 est le diagramme de fonctionnement correspondant à la structure de la figure 11.

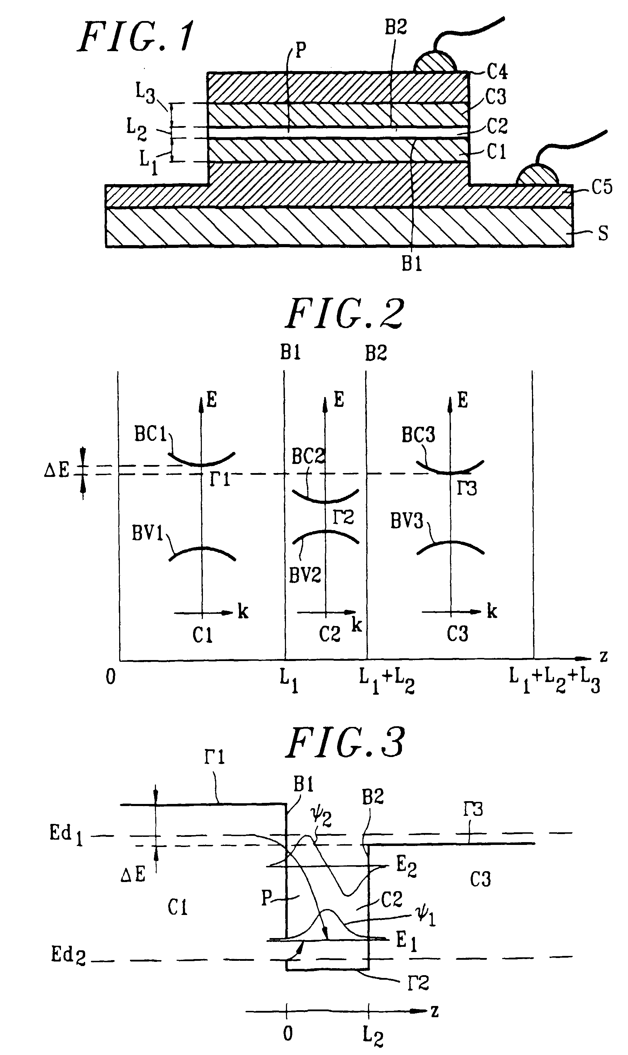

Les figures 1 à 5 concernent une structure à puits quantique unique et ces figures sont destinées à faciliter la compréhension de l'invention qui porte sur une structure à puits quantiques multiples.

La figure 1 montre, en coupe, une structure de détecteur photoélectrique à un puits quantique unique donnée pour faciliter la compréhension ultérieure de l'invention, constituée par une superposition de trois couches déposées sur un substrat S, par l'intermédiaire d'une première couche C5 de contact électrique, à savoir une couche C1 d'épaisseur L1 en un premier matériau semiconducteur formant une barrière amont B1, une couche intermédiaire C2 d'épaisseur L2 en un deuxième matériau semiconducteur formant le puits P, et une couche C3 d'épaisseur L3 en un troisième matériau semiconducteur formant barrière aval B2. La couche C1 est recouverte d'une deuxième couche C4 de contact électrique.

On a représenté très schématiquement sur la figure 2 la structure de bandes dans chacune des couches C1, C2 et C3, en faisant apparaître les bandes de conduction BC1, BC2 et BC3 et de valence BV1, BV2 et BV3. Dans une telle structure à un seul puits quantique, la composition en matériau semiconducteur est constante dans toute l'épaisseur de chaque couche. Sur le schéma de la figure 2, les bandes de conduction, par exemple, présentent des extrema respectifs, ici des minima, aux centres Γ1, Γ2 et Γ3 des zones de Brillouin.

Les positions respectives des différentes bandes électroniques dépendent essentiellement de la composition chimique des matériaux semiconducteurs. La conductibilité électrique dans le détecteur photoélectrique ainsi constitué est assurée par la propagation de porteurs de charge donnée, électrons ou trous, dans une bande électronique donnée, bande de conduction ou de valence, dans le sens de la barrière amont B1 à la barrière aval B2.

La figure 3 montre le diagramme d'énergie d'un puits quantique réalisé par les minima Γ1, Γ2, Γ3 des bandes de conduction BC1, BC2, BC3, pris au centre de la zone de Brillouin de chaque couche.

Dans le puits de potentiel de la couche C2, le confinement des porteurs produit des niveaux d'énergie quantifiés $E_1$, $E_2$, .... $E_n$, ... dont la valeur est donnée approximativement par

$$E_n = \frac{\hbar^2}{2m} \left(\frac{n\pi}{L_2}\right)^2 \quad n = 1, 2, ...$$

où $\hbar$ est la constante de Planck normalisée et m la masse des porteurs.

On constate que plus le puits est étroit et plus la différence d'énergie entre les deux premiers niveaux $E_1$ et $E_2$ est grande. Il est donc possible d'ajuster les dimensions du puits en fonction de la longueur d'onde de détection désirée.

Les fonctions d'onde $\psi_n$ associées aux niveaux d'énergie $E_n$ sont données en première approximation par :

$$\psi_n = A \sin\left(\frac{n\pi z}{L_2}\right) \quad n = 1, 2, 3, ....$$

A étant une constante de normalisation.

Pour peupler en électrons le niveau le plus bas $E_1$ de la structure du puits quantique, on dope les matériaux semiconducteurs en impuretés qui créent soit un niveau de donneurs $E_{d1}$ au voisinage des bandes de conduction BC1 et BC3 des couches C1 et C3, soit un niveau de donneurs $E_{d2}$ à proximité du niveau fondamental E1. Les électrons viennent alors peupler le niveau $E_1$. De même, pour peupler en trous les premiers niveaux de la bande de valence, on dopera de manière appropriée les matériaux semiconducteurs par des accepteurs d'électrons.

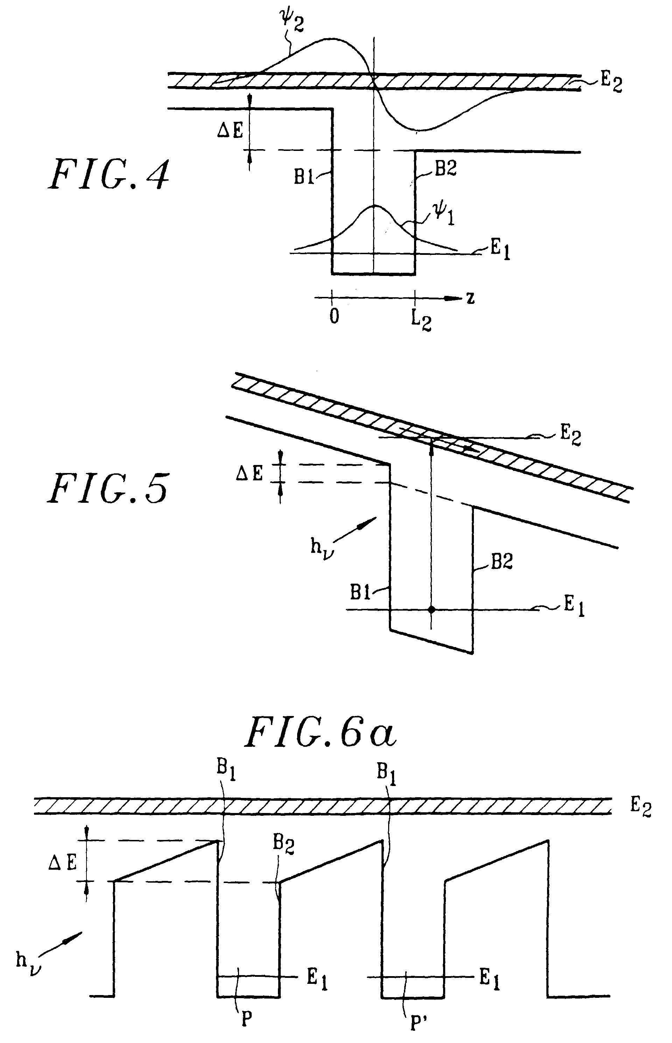

Sur la figure 3, le niveau d'énergie $E_2$ correspondant au premier état excité de la structure du puits quantique se trouve confiné à l'intérieur du puits, ce qui a pour conséquence que les porteurs qui s'y trouvent promus à la suite de l'absorption d'un photon d'énergie $h\nu = E_2 - E_1$ ont une probabilité assez faible de se propager et donc de contribuer de façon sensible au signal photoélectrique. De manière à augmenter cette probabilité de propagation, il y a avantage, comme l'indique la figure 4 en champ nul, à réaliser les transitions optiques entre un niveau confiné $E_1$ du puits et une minibande $E_2$ d'énergie supérieure à la hauteur de la barrière aval B2.

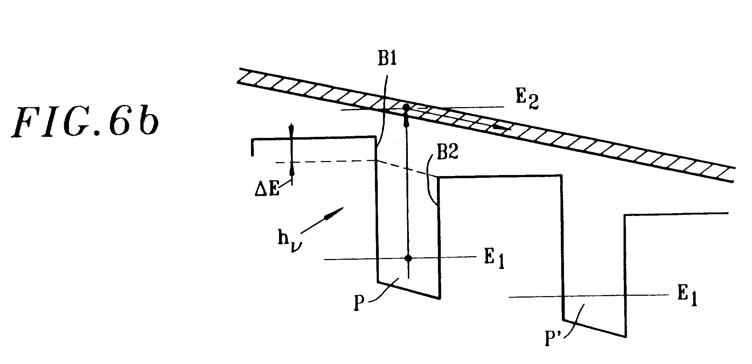

Dans ce dernier cas, la figure 5 montre le mécanisme de fonctionnement du puits quantique sous un champ électrique non nul. Un photon d'énergie $h\nu$ est absorbé dans le puits quantique par un porteur, un électron par exemple, d'énergie $E_1$ pour atteindre dans la minibande le niveau d'énergie $E_2$. L'électron soumis au champ électrique extérieur appliqué peut alors se propager à travers la structure, mais l'électron circulant dans la minibande a une certaine probabilité, au passage du puits, d'être capturé par la structure pour revenir dans l'état d'énergie minimum $E_1$ de ce puits.

Dans le but de limiter cette probabilité de capture, la composition des premier et troisième matériaux semiconducteurs est avantageusement telle que, au niveau des barrières B1 et B2, l'énergie du minimum $\Gamma 1$ de la bande de conduction BC1 dans la première couche C1 du premier matériau semiconducteur est supérieure à l'énergie du minimum $\Gamma 3$ de la bande de conduction BC3 dans la troisième couche C3 du troisième matériau semiconducteur, la différence d'énergie $\Delta E$ étant supérieure à l'énergie maximale des phonons longitudinaux optiques dans le deuxième matériau semiconducteur du puits quantique P.

Cette structure de puits quantique dans laquelle les porteurs sont des électrons et la bande électronique concernée la bande de conduction peut être réalisée à l'aide de matériaux semiconducteurs à base d'arséniure de gallium, de formule générale $Ga_xAl_{1-x}As$. En particulier, le premier matériau semiconducteur de la première couche C1 peut avoir pour formule $Ga_{x_1-1}Al_{1-x_1}As$, le deuxième matériau semiconducteur de la deuxième couche C2 de puits peut être de GaAs, le troisième matériau semiconducteur de la troisième couche C3 ayant pour formule

$$Ga_{x_3}Al_{1-x_3}As,$$

avec

$$x_1 > x_3 \text{ et } x_1 - x_3 > 0{,}05$$

de manière à avoir une différence d'énergie $\Delta E$ entre barrières supérieure à 50 meV, elle-même supérieure à l'énergie des phonons longitudinaux optiques dans GaAs, AlAs et GaAlAs. Typiquement, $x_1$ et $x_3$ peuvent valoir 0,25 et 0,2. A titre d'exemple, les épaisseurs des différentes couches peuvent être : $L_1 = L_3 = 0{,}1$ µm et $L_2 = 6$ nm.

On a représenté sur les figures 6a et 6b une structure à puits quantiques multiples conforme à l'invention. Cette structure est formée d'un empilement alterné de couches du deuxième matériau semiconducteur de puits, GaAs par exemple, séparées par des couches d'un matériau semiconducteur présentant, de la barrière aval B2 d'un puits P à la barrière amont B1 du puits suivant P', dans le sens de propagation des porteurs, une composition chimique variant graduellement entre la composition du troisième matériau semiconducteur, $Ga_{x_3}Al_{1-x_3}As$ par exemple, à celle du premier matériau semiconducteur, $Ga_{x_1}Al_{1-x_1}As$ par exemple, avec $x_1 > x_3$.

On remarquera que dans le schéma de structure de la figure 3 où le niveau photoexcité $E_2$ est un état confiné dans le puits quantique, la transition $E_1 \rightarrow E_2$ présente une force d'oscillateur relativement élevée du fait du recouvrement important entre les fonctions d'ondes correspondantes. Par contre, le confinement de l'état excité $E_2$ a pour effet de limiter la probabilité, pour l'électron dans l'état excité $E_2$, de quitter le puits et de participer au courant. A l'inverse, la structure montrée sur la figure 4 est plus avantageuse quant à cette probabilité, mais l'étalement de la fonction d'onde est tel que la force d'oscillateur de la transition optique est plus faible.

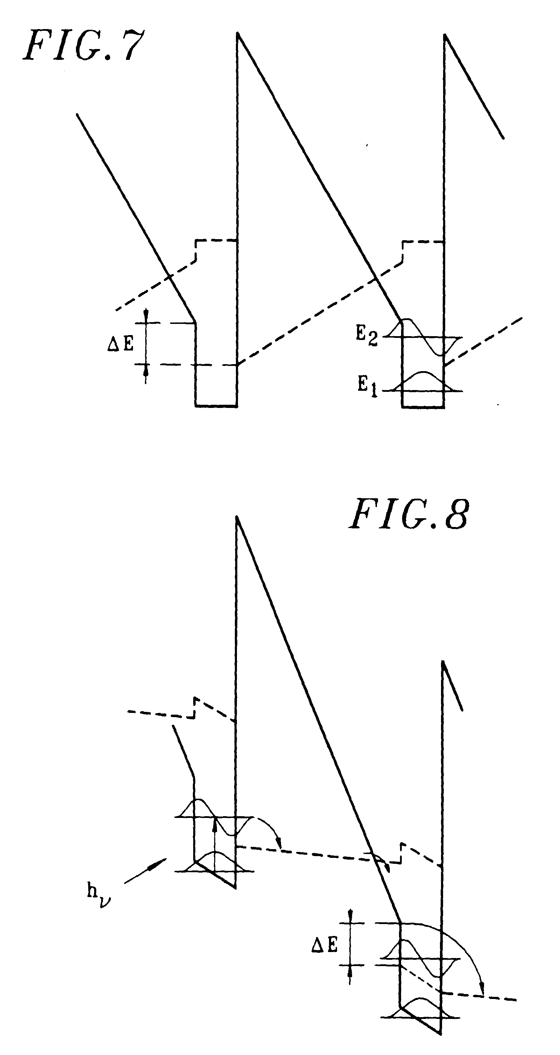

Aussi, la variante de réalisation de l'invention illustrée aux figures 7 et 8 a pour but, à la fois, d'améliorer la conductibilité électrique et d'augmenter le recouvrement des fonctions d'onde des états actifs optiquement. A cet effet, l'invention propose de confiner la fonction d'onde de l'état d'énergie $E_2$, mais d'autoriser le départ des porteurs photocréés grâce à la présence de niveaux d'énergie accessibles correspondant à un extremum, ici un minimum en bord de zone de Brillouin.

La structure de la figure 7 comporte une couche de puits quantique en $Ga_{0,9}Al_{0,1}As$ par exemple, entourée de part et d'autre d'une couche d'un matériau semiconducteur dont la composition varie graduellement, dans le sens de la conduction, de AlAs correspondant audit troisième matériau semiconducteur, à $Ga_{0,7}Al_{0,3}As$ par exemple, correspondant audit premier matériau semiconducteur, ces compositions pouvant bien entendu varier à condition toutefois que le minimum $\Gamma$ de la bande de conduction au centre de la zone de Brillouin dans le premier matériau soit supérieur au minimum X de la bande de conduction en bord de zone de Brillouin dans le troisième matériau, la différence d'énergie $\Delta E$ entre ces deux minima devant être supérieure à l'énergie maximale des phonons longitudinaux optiques dans GaAs. Pour une largeur de 9 nm et une composition de $Ga_{0,9}Al_{0,1}As$ du puits, le détecteur fonctionne au voisinage de

$2{,}7 \times 10^{13}$ Hz.

Le mécanisme du fonctionnement sous champ électrique d'un détecteur photoélectrique de ce type est illustré sur la figure 8. La transition optique entre les états confinés $E_1$ et $E_2$ est effectuée avec une force d'oscillateur importante. Le photoélectron ainsi créé se propage dans le puits jusqu'à la barrière aval B2 et pénètre dans le troisième matériau où, par désexcitation non radiative, il rejoint le niveau $X_3$ d'énergie minimale dans lequel il se maintient durant toute sa propagation dans la couche de matériau à composition graduellement variable jusqu'à croiser un minimum de la bande de conduction en centre de zone de Brillouin. L'électron continue alors sa trajectoire dans ce type d'état et atteint la barrière amont B1 où se produit le saut quantique au-dessus du puits entre le niveau en Γ du premier matériau semiconducteur et le niveau en X du troisième matériau semiconducteur.

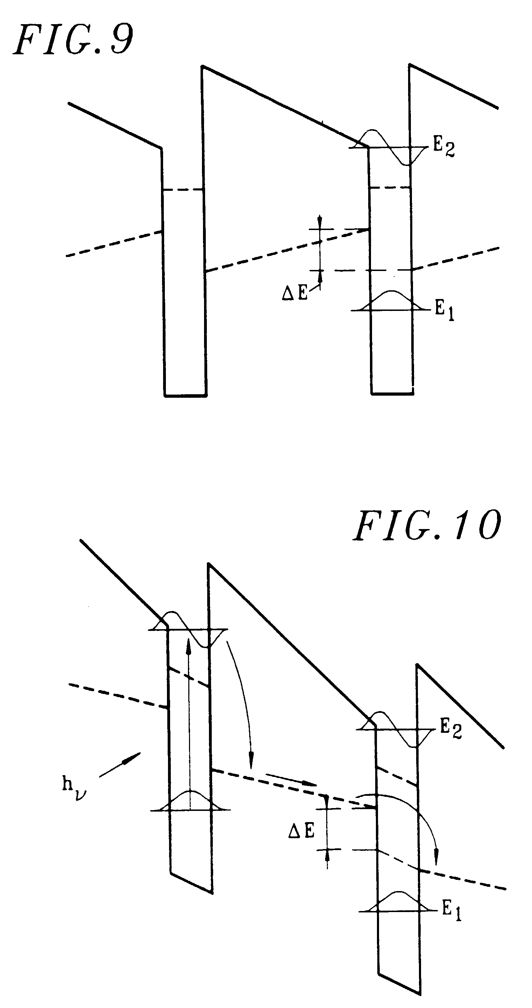

Les figures 9 et 10 montrent un détecteur photoélectrique, de structure analogue à celle décrit en regard des figures 7 et 8, dont la responsivité a été étendue à la gamme $5 \times 10^{13}$ - $10^{14}$ Hz. Le puits quantique proprement dit est réalisé par une couche de GaAs entouré de deux couches dont la composition varie graduellement d'un troisième matériau semiconducteur de composition $Ga_{0{,}2}Al_{0{,}8}As$ à un premier matériau semiconducteur de composition $Ga_{0{,}4}Al_{0{,}6}As$, par exemple. Dans ce type de structure, il importe que le minimum X de la bande de conduction en bord de zone de Brillouin dans le premier matériau soit supérieur au minimum X de la bande de conduction en bord de zone de Brillouin dans le troisième matériau, la différence d'énergie ΔE entre ces deux minima devant être supérieure à l'énergie maximale des phonons longitudinaux optiques dans GaAs. Pour un puits de GaAs de 3 nm, le détecteur fonctionne au voisinage du $10^{14}$ Hz.

Comme le montre la figure 10, lors du fonctionnement du photodétecteur, un électron, promu dans le niveau d'énergie $E_2$ par absorption d'un photon de la gamme $5 \times 10^{13}$ - $10^{14}$ Hz se désexcite pour atteindre le minimum en X du troisième matériau semiconducteur et se propage dans la couche de composition variable jusqu'à la barrière amont B1 où il se trouve alors au minimum en X du premier matériau semiconducteur. Le passage d'un niveau X à l'autre à travers le puits quantique est effectué, conformément aux dispositions de la présente invention, par saut de potentiel.

Entre le système GaAs/GaAlAs, l'invention s'applique également à d'autres systèmes de composés III-V comme GaInAs/GaAlInAs, GaInAs/GaInAsP, GaSb/GaAlSb.

L'invention peut également s'appliquer à des photodétecteurs utilisant les trous de la bande de valence comme porteurs majoritaires. Il a en effet été démontré que les détecteurs photoélectriques à puits quantiques basés sur ce principe présentaient de bonnes détectivités. Leur intérêt essentiel est de permettre une mise en oeuvre du photodétecteur sous incidence normale : en effet, la transition intra-bande de valence entre le premier niveau $E_1$ de trous lourds et le second niveau $E_2$ est permise dans cette configuration.

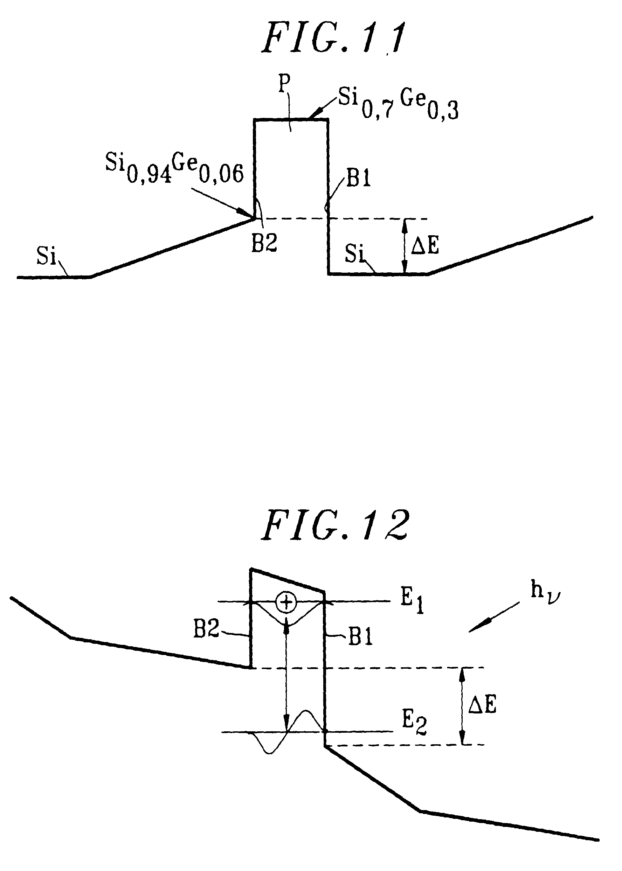

Le problème essentiel d'une telle structure est le faible gain dû à la lente vitesse de dérive des trous. Ils ont en conséquence 80 à 100 % de chances d'être capturés au passage d'un seul puits. Une structure conforme à l'invention doit permettre de réduire cette probabilité de capture comme dans le cas des électrons. Les figures 11 et 12 montrent une structure de ce type qui permet une détection au voisinage de $2{,}7 \times 10^{13}$ Hz pour des matériaux semiconducteurs de forme generale $Si_xGe_{1-x}$.

Dans cet exemple, le premier matériau semiconducteur formant la barrière amont B1 est une couche de silicium pur (x=0). Le puits quantique P proprement dit est constitué par une couche de 0,004 μm d'épaisseur d'un deuxième materiau semiconducteur de formule $Si_{0{,}7}Ge_{0{,}3}$. Enfin, la structure est complétée par une troisième couche présentant une composition variant graduellement de celle d'un troisième matériau semiconducteur de formule $Si_{0{,}94}Ge_{0{,}06}$ au niveau de la barrière aval B2, à celle du silicium pur.

Le diagramme d'énergie représenté aux figures 11 et 12 est tracé en prenant pour référence les maxima des bandes de valence au centre des zones de Brillouin pour chacun des matériaux semiconducteurs considérés. La différence d'énergie ΔE entre ces maxima pour les premier et troisième matériaux est de 60 meV, valeur supérieure à l'énergie maximale des phonons longitudinaux optiques du silicium qui est de 57 meV.

La transition entre l'état confiné $E_1$ et l'état résonant $E_2$ au bord du puits s'effectue autour de la fréquence de $2{,}7 \times 10^{13}$ Hz.

Ce cas particulier de structure de détecteur photoélectrique à puits quantiques est particulièrement important car elle permet a priori une intégration facile avec une électronique de commande et de traitement VLSI.

## Revendications

1. Détecteur photoélectrique présentant une structure à puits quantiques multiples constitués chacun par une barrière amont (B1) réalisée en un premier matériau semiconducteur, un puits (P) réalisé en un deuxième matériau semiconducteur, et une barrière aval (B2) réalisée en un troisième matériau semiconducteur, chaque matériau semiconducteur étant défini par sa composition chimique, et la conductibilité électrique dans le détecteur étant assurée par propagation, dans le sens allant de la barrière amont à la barrière aval, de porteurs de charge dans une bande électronique de type donné présentant, dans chacun desdits matériaux, un extremum d'énergie, lesdits matériaux semiconducteurs étant au moins partiellement dopés en porteurs, les premier et troisième matériaux semiconducteurs ayant une composition chimique telle que la différence ($\Delta$E) d'énergie, au niveau desdites barrières (B1, B2), entre l'extremum d'énergie de ladite bande électronique dans le premier matériau semiconducteur et l'extremum d'énergie de ladite bande électronique dans le troisième matériau semiconducteur est supérieure en valeur absolue à l'énergie maximale des phonons longitudinaux optiques dans le deuxième matériau semiconducteur constituant le puits (P), ladite structure étant formée d'un empilement alterné de couches du deuxième matériau semiconducteur séparées par des couches d'un matériau semiconducteur présentant, de la barrière aval (B2) d'un puits (P) à la barrière amont (B1) du puits (P') suivant dans le sens de propagation des porteurs, une composition chimique variant graduellement de la composition du troisième matériau semiconducteur à celle du premier matériau semiconducteur.

2. Détecteur photoélectrique selon la revendication 1, caractérisé en ce que, lesdits matériaux semiconducteurs étant au moins partiellement dopés en donneurs, lesdits porteurs sont des électrons et ladite bande électronique la bande de conduction.

3. Détecteur photoélectrique selon la revendication 2, caractérisé en ce que ledit extremum d'énergie de ladite bande électronique dans ledit premier matériau semiconducteur est le minimum ($\Gamma_1$) de la bande de conduction au centre de la zone de Brillouin, et en ce que ledit extremum de ladite bande électronique dans ledit troisième matériau est le minimum ($\Gamma_3$) de la bande de conduction au centre de la zone de Brillouin.

4. Détecteur photoélectrique selon la revendication 2, caractérisé en ce que ledit extremum d'énergie de ladite bande électronique dans ledit premier matériau semiconducteur est le minimum ($\Gamma_1$) de la bande de conduction au centre de la zone de Brillouin, et en ce que ledit extremum d'énergie de ladite bande électronique dans ledit troisième matériau semiconducteur est le minimum (X) de la bande de conduction en bord de zone de Brillouin.

5. Détecteur photoélectrique selon la revendication 2, caractérisé en ce que ledit extremum d'énergie de ladite bande électronique dans ledit premier matériau semiconducteur est le minimum (X) de la bande de conduction en bord de zone de Brillouin, et en ce que ledit extremum d'énergie de ladite bande électronique dans ledit troisième matériau semiconducteur est le minimum (X) de la bande de conduction en bord de zone de Brillouin.

6. Détecteur photoélectrique selon la revendication 1, caractérisé en ce que, lesdits matériaux semiconducteurs étant au moins partiellement dopés en accepteurs, lesdits porteurs sont des trous et ladite bande électronique la bande de valence.

7. Détecteur photoélectrique selon la revendication 6, caractérisé en ce que ledit extremum d'énergie de ladite bande électronique dans ledit premier matériau semiconducteur est le maximum de la bande de valence au centre de la zone de Brillouin, et en ce que ledit extremum d'énergie de ladite bande électronique dans ledit troisième matériau est le maximum de la bande de valence au centre de la zone de Brillouin.

8. Détecteur photoélectrique selon l'une quelconque des revendications 2 à 7, caractérisé en ce que lesdits matériaux semiconducteurs sont des composés des éléments des colonnes III et V de la classification périodique des éléments.

9. Détecteur photoélectrique selon la revendication 8, caractérisé en ce que lesdits matériaux semiconducteurs répondent à la formule chimique générale de $Ga_xAl_{1-x}As$.

10. Détecteur photoélectrique selon l'une des revendications 6 ou 7, caractérisé en ce que lesdits matériaux semiconducteurs répondent à la formule chimique generale $Si_xGe_{1-x}$.

**Patentansprüche**

1. Photoelektrischer Detektor, der eine Struktur mit mehreren Quantentöpfen aufweist, die jeweils durch eine vordere Barriere (B1), die aus einem ersten Halbleitermaterial besteht, einen Topf (P), der aus einem zweiten Halbleitermaterial besteht, und eine hintere Barriere (B2), die aus einem dritten Halbleitermaterial besteht, gebildet werden, wobei jedes Halbleitermaterial durch seine chemische Zusammensetzung definiert ist und die elektrische Leitfähigkeit in dem Detektor durch Propagation von Ladungsträgern in der Richtung von der vorderen Barriere zu der hinteren Barriere in einem elektronischen Band einer gegebenen Art gewährleistet wird, das in jedem der genannten Materialien einen Extremwert der Energie aufweist, und die Halbleitermaterialien zumindest teilweise mit Ladungsträgern dotiert sind, wobei das erste und das dritte Halbleitermaterial eine derartige chemische Zusammensetzung aufweisen, daß bei den Barrieren (B1, B2) die Energiedifferenz ($\Delta$E) zwischen dem Extremwert der Energie des elektronischen Bandes in dem ersten Halbleitermaterial und dem Extremwert der Energie des elektronischen Bandes in dem dritten Halbleitermaterial betragsmäßig größer als die maximale Energie der optischen longitudinalen Phononen in dem zweiten Halbleitermaterial ist, welches den Topf (P) bildet, wobei die Struktur durch eine alternierende Schichtstruktur mit Schichten aus dem zweiten Halbleitermaterial gebildet wird, welche durch Schichten aus einem Halbleitermaterial getrennt werden, das eine chemische Zusammensetzung aufweist, die sich graduell von der Zusammensetzung des dritten Halbleitermaterials zu derjenigen des ersten Halbleitermaterials von der hinteren Barriere (B2) eines Topfes (P) zu der vorderen Barriere (B1) des in der Propagationsrichtung der Ladungsträger folgenden Topfes (P') ändert.

2. Photoelektrischer Detektor nach Anspruch 1, dadurch **gekennzeichnet**, daß die Halbleitermaterialien zumindest teilweise mit Donatoren dotiert sind, wobei die Ladungsträger Elektronen sind und das elektronische Band das Leitungsband ist.

3. Photoelektrischer Detektor nach Anspruch 2, dadurch **gekennzeichnet**, daß der Extremwert der Energie des elektronischen Bandes in dem ersten Halbleitermaterial das Minimum ($\Gamma_1$) des Leitungsbandes im Zentrum der Brillouin-Zone ist und daß der Extremwert des elektronischen Bandes in dem dritten Material das Minimum ($\Gamma_3$) des Leitungsbandes im Zentrum der Brillouin-Zone ist.

4. Photoelektrischer Detektor nach Anspruch 2, dadurch **gekennzeichnet**, daß der Extremwert der Energie des elektronischen Bandes in dem ersten Halbleitermaterial das Minimum ($\Gamma_1$) des Leitungsbandes im Zentrum der Brillouin-Zone ist und daß der Extremwert der Energie des elektronischen Bandes in dem dritten Halbleitermaterial das Minimum (X) des Leitungsbandes am Rand der Brillouin-Zone ist.

5. Photoelektrischer Detektor nach Anspruch 2, dadurch **gekennzeichnet**, daß der Extremwert der Energie des elektronischen Bandes in dem ersten Halbleitermaterial das Minimum (X) des Leitungsbandes am Rand der Brillouin-Zone ist und daß der Extremwert der Energie des elektronischen Bandes in dem dritten Halbleitermaterial das Minimum (X) des Leitungsbandes am Rand der Brillouin-Zone ist.

6. Photoelektrischer Detektor nach Anspruch 1, dadurch **gekennzeichnet**, daß die Ladungsträger Löcher sind und das elektronische Band das Valenzband ist, wobei die besagten Halbleitermaterialien zumindest teilweise mit Akzeptoren dotiert sind.

7. Photoelektrischer Detektor nach Anspruch 6, dadurch **gekennzeichnet**, daß der Extremwert der Energie des elektronischen Bandes in dem ersten Halbleitermaterial das Maximum des Valenzbandes im Zentrum der Brillouin-Zone ist und daß der Extremwert der Energie des elektronischen Bandes in dem dritten Material das Maximum des Valenzbandes im Zentrum der Brillouin-Zone ist.

8. Photoelektrischer Detektor nach einem der Ansprüche 2 bis 7, dadurch **gekennzeichnet**, daß die Halbleitermaterialien aus Elementen der Gruppen III und V des Periodensystems der Elemente bestehen.

9. Photoelektrischer Detektor nach Anspruch 8, dadurch **gekennzeichnet**, daß die Halbleitermaterialien unter die allgemeine chemische Formel $Ga_xAl_{1-x}As$ fallen.

10. Photoelektrischer Detektor nach einem der Ansprüche 6 oder 7, dadurch **gekennzeichnet**, daß die Halbleitermaterialien unter die allgemeine chemische Formel $Si_xGe_{1-x}$ fallen.

**Claims**

1. Photoelectric detector presenting a multiple quantum well structure, each well structure each comprising an upside barrier (B1) made from a first semiconductor material, a well (P) made from a second semiconductor material, and a downside barrier (B2) made from a third semiconductor material, each semiconductor material being defined by its chemical composition, and the electric conductibility in the detector being ensured by propagation, in the upside barrier to the downside barrier direction, of charge carriers in a given electronic band, presenting an energy extremum in each of said materials, said semiconductor materials being at least partly doped with carriers, the chemical composition of the first and third semiconductor materials being such that the difference in energy ($\Delta$E), at the level of said barriers (B1, B2), between the energy extremum of said electronic band in the first semiconductor material and the energy extremum of said electronic band in the third semiconductor material is greater in absolute value than the maximum energy of the optical longitudinal phonons in the second semiconductor material making up the well (P), said structure being formed from an alternating stack of layers of the second well semiconductor material separated by layers of a semiconductor material presenting, from the downside barrier (B2) of a well (P) to the upside barrier (B1) of the following well (P'), in the direction of carrier propagation, a chemical composition varying gradually from the composition of the third semiconductor material to that of the first semiconductor material.

2. Photoelectric detector according to claim 1, characterised in that said semiconductor materials are at least partly doped with donors, said carriers being electrons and said electronic band the conduction band.

3. Photoelectric detector according to claim 2, characterised in that said energy extremum of said electronic band in said first semiconductor material is the minimum ($\Gamma_1$) of the conduction band at the Brillouin zone centre, and in that said extremum of said electronic band in said third semiconductor material is the minimum ($\Gamma_3$) of the conduction band at the Brillouin zone centre.

4. Photoelectric detector according to claim 2, characterised in that said energy extremum of said electronic band in said first semiconductor material is the minimum ($\Gamma_1$) of the conduction band at the Brillouin zone centre, and in that said energy extremum of said electronic band in said third semiconductor material is the minimum (X) of the conduction band in the Brillouin zone edge.

5. Photoelectric detector according to claim 2, characterised in that said energy extremum of said electronic band in said first semiconductor material is the minimum (X) of the conduction band in the Brillouin zone centre, and in that said energy extremum of said electronic band in said third semiconductor material is the minimum (X) of the conduction band in the Brillouin zone edge.

6. Photoelectric detector according to claim 1, characterised in that said semiconductor materials are at least partly doped with acceptors, said carriers being holes and said electronic band the valence band.

7. Photoelectric detector according to claim 6, characterised in that said energy extremum of said electronic band in said first semiconductor material is the maximum of the valence band at the Brillouin zone centre, and in that said energy extremum of said electronic band in said third material is the maximum of the valency band at the Brillouin zone centre.

8. Photoelectric detector according to any one of claims 2 to 7, characterised in that said semiconductor materials are compounds of elements from columns III and V of the periodic classification of elements.

9. Photoelectric detector according to claim 8, characterised in that said semiconductor materials comply with the general chemical formula $Ga_xAl_{l-x}As$.

10. Photoelectric detector according to claim 6 or claim 7, characterised in that said semiconductor materials comply with the general chemical formula $Si_xGe_{1-x}$.

*FIG.1*

*FIG.2*

*FIG.3*

*FIG.4*

*FIG.5*

*FIG.6α*

FIG.6b

FIG.7

FIG.8

*FIG.9*

*FIG.10*

# FIG. 11

# FIG. 12